# EUROPÄISCHE PATENTANMELDUNG

(11) **EP 2 107 615 A2**
(43) Veröffentlichungstag der Anmeldung: **07.10.2009**
(21) Anmeldenummer: 09165787.4
(22) Anmeldetag: 07.12.2007
(51) Int. Cl.: H01L 31/0224, H01L 31/068, H01L 31/18

(54) **Solarzelle und Verfahren zur Herstellung einer Solarzelle**

(30) Priorität: 08.12.2006 DE 102006058267
(62) Teilanmeldung aus: 07847986.2
(71) Anmelder: Q-Cells SE, 06766 Bitterfeld-Wolfen (DE)
(72) Erfinder: Müller, Jörg, Dr., 06792, Sandersdorf (DE); Wade, Robert, 04109, Leipzig (DE); Hlusiak, Markus, 06766, Wolfen (DE)
(74) Vertreter: Müller, Wolfram Hubertus

(57) **Zusammenfassung**

Die Erfindung betrifft eine Solarzelle (10), die ein planares Halbleitersubstrat (13) mit einer Vorderseite (11) und einer Rückseite (12), eine Mehrzahl von Löchern (14), die die Vorderseite (11) und die Rückseite (12) verbinden, und ausschließlich auf der Rückseite (12) angeordnete stromsammelnde elektrische Kontakte (31, 32) aufweist. Die Vorderseite (11) weist hochdotierte Bereiche (21, 25) und schwach dotierte Bereiche (22) eines ersten Typs derart auf, dass die Löcher (14) jeweils in einem hochdotierten Bereich (21) liegen oder an einen solchen angrenzen. Erfindungsgemäß weist die Vorderseite (11) mindestens einen Bereich (15) ohne Löcher auf und umfassen die hochdotierten Bereiche einen oder mehrere Bereiche (25), die sich in den mindestens einen lochfreien Bereich (15) erstrecken.

## Beschreibung

Die Erfindung betrifft eine Solarzelle und Verfahren zur Herstellung einer Solarzelle.

### HINTERGRUND DER ERFINDUNG

Eine Emitter Wrap-Through- (EWT-) Solarzelle besitzt auf der Vorderseite keine Metallisierung. Der Emitter wird über eine Vielzahl kleiner Löcher (d <100 µm) auf die Zellrückseite geleitet und dort kontaktiert. Der lichtgenerierte Strom wird über den Emitter und die Löcher auf die Zellrückseite zu dort angeordneten Kontakten geleitet und dort abgegriffen.

Die Stärke der Emitterdotierung spielt eine wichtige Rolle. Eine höhere Dotierung bewirkt einerseits einen kleineren Schichtwiderstand und trägt somit zur Verringerung von ohmschen Verlusten bei. Außerdem ist der Kontaktwiderstand zwischen Emitter und Metallisierung bei einer hohen Emitterdotierung deutlich geringer. Eine hohe Dotierung verringert andererseits die Fähigkeit der Zelle, insbesondere kurzwelliges Licht in Strom umzuwandeln (sogenannte Blauempfindlichkeit). Dementsprechend muss für die Dotierung ein Kompromiss zwischen guter Leitfähigkeit und Blauempfindlichkeit gewählt werden.

Zur Verringerung des effektiven Schichtwiderstands einer EWT-Solarzelle ist es beispielsweise aus der US 2005/0176164 A1 bekannt, in der Innenwand der Löcher der Zelle eine höhere Dotierung vorzunehmen als auf der Vorderseite der Zelle. Ein solches Konzept wird auch als selektiver Emitter oder selektives Dotieren bezeichnet. Aus der US 2005/0176164 A1 ist weiter bekannt (Fig. 3D dieser Druckschrift), auf der Vordereite einer EWT-Solarzelle einen hochdotierten Streifen auszubilden, der mehrere der Löcher umfasst.

Die US 7 144 751 B1 beschreibt eine Solarzelle, bei der in der Innenwand der Löcher der Solarzelle sowie entlang eines Rasters auf der Vorderseite der Solarzelle eine höhere Dotierung vorliegen.

Der vorliegenden Erfindung liegt die Aufgabe zu Grunde, eine Solarzelle mit einem geringen effektiven Schichtwiderstand bei gleichzeitig hoher Blauempfindlichkeit sowie Verfahren zur Herstellung einer solchen Solarzelle bereitzustellen.

### ZUSAMMENFASSUNG DER ERFINDUNG

Die vorliegende Erfindung stellt in einem Erfindungsaspekt eine Solarzelle mit einer Mehrzahl von Löchern bereit, bei der die Vorderseite hochdotierte Bereiche und schwach dotierte Bereiche eines ersten Dotierungstyps derart aufweist, dass die Löcher der Solarzelle jeweils in einem hochdotierten Bereich liegen oder an einen solchen angrenzen. Dabei sind die hochdotierten Bereiche lokal um die Löcher der Solarzelle herum angeordnet. Die einzelnen lokalen hochdotierten Bereiche sind räumlich voneinander getrennt und bilden somit keine zusammenhängende Struktur auf der Vorderseite der Solarzelle. Es ist somit vorgesehen, dass der Vorderseiten-Emitter keine homogene Dotierung aufweist, sondern vielmehr in unmittelbarer Umgebung der Löcher hochdotiert ist. Durch diese spezielle Dotierung besitzt der überwiegende Teil der Vorderseite, der schwach dotiert ist, einen Emitter mit hoher Blauempfindlichkeit. Durch die hochdotierten Bereiche werden gleichzeitig der Serienwiderstand und der Kontaktwiderstand reduziert.

Für den Serienwiderstand einer Solarzelle ist unter anderem die Stärke der Dotierung der Bereiche der Vorderseite in unmittelbarer Nähe zu den Löchern ausschlaggebend. Der Grund dafür liegt darin, dass der Strom in diesen Bereichen annähernd radial auf das Loch zufließt und somit in diesen Bereichen die höchste Stromdichte auftritt. Wird der Umkreis der Löcher somit hochdotiert, so nimmt der nachteilige elektrische Widerstand ab. Der Umkreis der Löcher, der eine hohe Dotierung erfährt, weist beispielsweise einen Radius zwischen von einigen 100 µm auf.

Bei der erfindungsgemäßen Solarzelle handelt es sich beispielsweise um eine EWT-Solarzelle oder eine Metallization Wrap-Through- (MWT-) Solarzelle.

In einer Ausgestaltung der Erfindung bildet die Vorderseite hochdotierte Bereiche aus, die im wesentlichen kreisförmig sind. Dabei kann vorgesehen sein, dass die hochdotierten Bereiche einen Kreisring mit einem Innenradius und einem Außenradius bilden, wobei der Innenradius dem Radius des Lochs entspricht, das der jeweilige Kreisring umgibt. Die Radiendifferenz zwischen Außenradius und Innenradius liegt z.B. zwischen 50 µm und 300 µm, insbesondere zwischen 100 µm und 200 µm.

In einer anderen Ausgestaltung bildet die Vorderseite hochdotierte Bereiche aus, die sternfömig oder fächerförmig von den jeweiligen Löchern abstrahlen. Dabei umfassen die hochdotierten Bereiche, die sternfömig oder fächerförmig von den jeweiligen Löchern abstrahlen, in einer Ausgestaltung jeweils fingerfömige Bereiche.

In einem weiteren Erfindungsaspekt weist das Halbleitersubstrat und damit die Vorderseite der Solarzelle Bereiche ohne Löcher auf. Hiefür kann es verschiedene Gründe geben. Beispielsweise gibt es bestimmte Bereiche der Solarzelle, in denen Löcher unerwünscht sind. Dies sind insbesondere Bereiche, bei denen an der Rückseite keine Löcher möglich sind, beispielsweise, da dort Lötstellen oder Stromsammelschienen (sogenannte Bus-Bars) mit der Basispolarität des Halbleitersubstrats realisiert sind oder weil es sich um Randbereiche der Zelle handelt. Des weiteren ist es grundsätzlich aus technologischen Gründen erstrebenswert, die Anzahl der Löcher möglichst gering zu halten. Solche technologischen Gründe sind beispielsweise die Notwendigkeit des Bohrens der Löcher oder die Anzahl der Kontaktfinger und Bus-Bars auf der Rückseite. Andererseits ist es für einen geringen Serienwiderstand vorteilhaft, eine möglichst große Anzahl an Löchern vorzusehen. Dadurch ist bei z.B. EWT-Solarzellen immer ein Kompromiss bezüglich der Löcherzahl zu treffen. Sofern, wie durch die vorliegende Erfindung, ein geringer Serienwiderstand auch bei einer vergleichsweisen geringen Anzahl von Löchern realisiert werden kann, können die Löcher einen relativ großen Abstand zueinander aufweisen, so dass zwischen den Löchern größere Bereiche ohne Löcher liegen.

In solchen lochfreien Bereichen ist die Entfernung zum nächsten Loch und damit der Strompfad auf der Vorderseite deutlich größer als gewünscht. Dies führt in diesen Bereichen zu einem großen parasitären elektrischen Serienwiderstand. Es ist nun gemäß diesem weiteren Erfindungsaspekt vorgesehen, dass die hochdotierten Bereiche der Vorderseite Bereiche umfassen, die sich in die lochfreien Bereiche erstrecken. Beispielsweise handelt es sich um fingerförmige Bereiche, die sich fächerartig in die lochfreien Bereiche erstrecken. Diese fingerförmigen, hochdotierten Bereiche stellen gut leitende Strompfade dar, die den in den lochfreien Bereichen aufgesammelten Strom zu einem Loch transportieren. Hierdurch reduzieren die fingerförmigen, hochdotierten Bereiche den Serienwiderstand. Gleichzeitig sorgt ihre Transparenz für eine gute Lichtausnutzung.

Die hochdotierten Bereiche insgesamt und insbesondere die fingerförmigen Bereiche, die sich in lochfreie Bereiche erstrecken, können in einer Ausgestaltung in Gräben im Halbleitersubstrat ausgebildet sein.

Ein erfindungsgemäßes Verfahren zur Herstellung einer Emitter-Wrap-Through-(EWT)-Solarzelle umfasst die folgenden Schritte:
- Bereitstellen eines planaren Halbleitersubstrats mit einer Vorderseite und einer Rückseite,
- Ganzflächiges Aufbringen einer Diffusionsmaske zumindest auf die Vorderseite,
- Herstellen einer Mehrzahl von Löchern im Halbleitersubstrat, die die Vorderseite und die Rückseite verbinden,
- selektives Entfernen der Diffusionsmaske derart, dass die Diffusionsmaske zumindest in Bereichen, in denen die Löcher liegen oder an welche die Löcher angrenzen, entfernt wird,
- Vornahme einer starken Diffusion mit einem Dotierstoff eines ersten Typs, wobei die Bereiche der Vorderseite, in denen die Diffusionsmaske selektiv entfernt wurde, hochdotiert werden,
- Komplettes Entfernen der Diffusionsmaske zumindest von der Vorderseite,
- Vornahme einer leichten Diffusion mit einem Dotierstoff des ersten Typs.

Diese Verfahrensschritte müssen nicht notwendigerweise vollständig in der angegebenen Reihenfolge ausgeführt werden. Beispielsweise kann vorgesehen sein, dass die Löcher erst nach dem selektiven Entfernen der Diffusionsmaske ausgebildet werden, oder auch bereits vor dem Aufbringen der Diffusionsmaske.

Ein weiteres erfindungsgemäßes Verfahren zur Herstellung einer Emitter-Wrap-Through-(EWT)-Solarzelle sieht folgende Schritte vor:
- Bereitstellen eines planaren Halbleitersubstrats mit einer Vorderseite und einer Rückseite,
- Herstellen einer Mehrzahl von Löchern im Halbleitersubstrat, die die Vorderseite und die Rückseite verbinden,
- Vornahme einer starken Diffusion mit einem Dotierstoff eines ersten Typs zumindest auf der Vorderseite, wobei die gesamte Vorderseite hochdotiert wird,
- Ganzflächiges Aufbringen einer Diffusionsmaske zumindest auf die Vorderseite,
- selektives Entfernen der Diffusionsmaske derart, dass die Diffusionsmaske nur noch in definierten Bereichen, in denen die Löcher liegen oder an welche die Löcher angrenzen, vorhanden ist, danach
- Entfernen der bei der starken Diffusion hochdotierten Bereiche in den Bereichen der Vorderseite, die außerhalb der Diffusionsmaske liegen, und
- Vornahme einer leichten Diffusion mit einem Dotierstoff des ersten Typs zumindest auf der Vorderseite,
- Komplettes Entfernen der Diffusionsmaske zumindest von der Vorderseite.

Bei dieser Verfahrensvariante wird also zunächst ganzflächig die Vorderseite hochdotiert. Die Diffusionsmaske wird komplementär zu der Diffusionsmaske des Verfahrens des Anspruchs 24 strukturiert. Außerhalb der strukturierten Diffusionsmaske wird die hohe Dotierung wieder entfernt. Es erfolgt dann eine niedrige Dotierung in diesen Bereichen. Abschließend erfolgt ein komplettes Entfernen der Diffusionsmaske zumindest von der Vorderseite.

### BESCHREIBUNG VON AUSFÜHRUNGSBEISPIELEN DER ERFINDUNG

Die Erfindung wird nachfolgend unter Bezugnahme auf die Figuren der Zeichnung anhand ihrer Ausführungsbeispiele näher erläutert. Es versteht sich, dass diese Figuren nur typische Ausführungsformen der Erfindung darstellen und daher nicht als ihren Umfang begrenzend zu erachten sind. Es zeigen:
- Fig. 1: die Oberseite einer EWT-Solarzelle mit lokal ausgebildeten hochdotierten Bereichen;
- Fig. 2: einen Schnitt durch einen Teilbereich der EWT-Solarzelle der Fig. 1;
- Fig. 3: schematisch den Stromfluss auf der Vorderseite einer EWT-Solarzelle;
- Fig. 4: eine Draufsicht auf ein weiteres Ausführungsbeispiel einer EWT-Solarzelle mit lokal hochdotierten Bereichen;
- Fig. 5: eine auf ein Halbleitersubstrat aufgebrachte Diffusionsmaske zur Maskierung einer starken Diffusion, wobei die Diffusionsmaske im Bereich von Löchern des Halbleitersubstrats kreisförmige, lokale Aussparungen aufweist;
- Fig. 6: eine auf ein Halbleitersubstrat aufgebrachte Diffusionsmaske zur Maskierung einer starken Diffusion, wobei die Diffusionsmaske linienförmig, jeweils eine Lochreihe enthaltende Aussparungen aufweist; und
- Fig. 7: eine im Stand der Technik bekannte Struktur stromsammelnder elektrischer Kontakte auf der Rückseite einer EWT-Solarzelle.

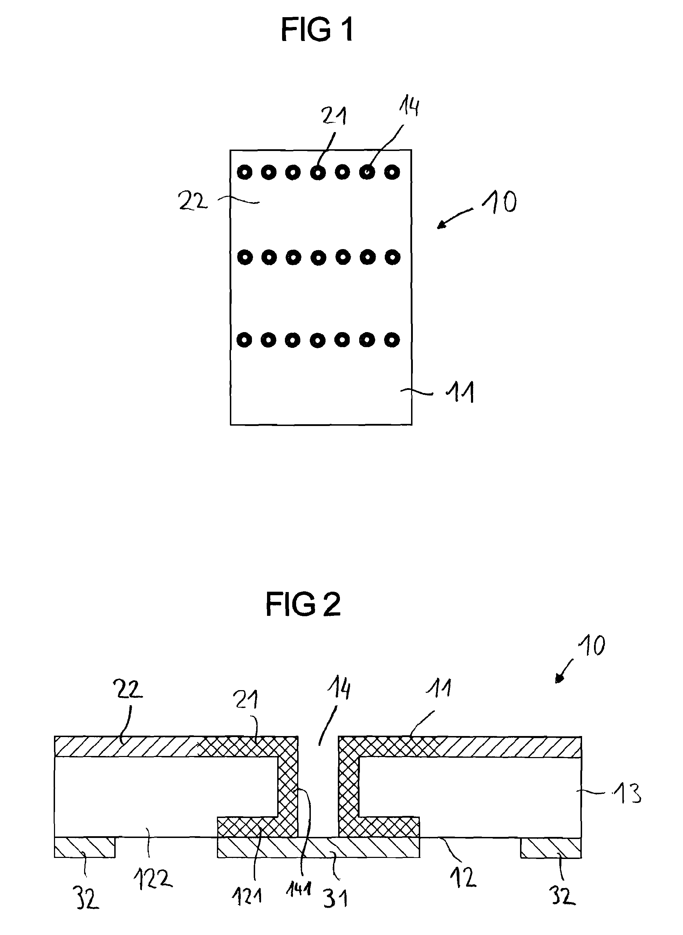

Die Figuren 1 und 2 zeigen eine EWT-Solarzelle mit auf der Oberseite selektiv ausgebildeten hochdotierten Bereichen. Die Solarzelle 10 umfasst ein Halbleitersubstrat 13, beispielsweise einen Siliziumwafer, mit einer Oberseite 11 und einer Unterseite 12. In dem Halbleitersubstrat sind eine Mehrzahl von Durchgangslöchern 14 ausgebildet, die die Oberseite 11 mit der Unterseite 12 verbinden. Die Löcher 14 sind rasterartig angeordnet, wobei der Abstand zwischen zwei Löchern in einer Richtung zwischen 0,2 und 0,8 mm liegt und in der Richtung senkrecht dazu beispielsweise 2 mm. Die Lochdurchmesser liegen typischerweise zwischen 30 und 100 µm.

Die Löcher 14 werden beispielsweise durch Laserbohren hergestellt. Jedoch sind auch andere Herstellungsverfahren wie z. B. Ätzverfahren oder mechanische Bohrverfahren denkbar.

Die Vorderseite 11 des Halbleitersubstrats 13 weist eine Dotierung eines ersten Typs auf, beispielsweise eine n-Dotierung. Das Halbleitersubstrat 13 selbst weist ebenfalls eine Dotierung auf, und zwar eines zweiten, entgegengesetzten Typs, beispielsweise eine p-Dotierung. Im Folgenden wird der Einfachheit halber von n-Dotierung und p-Dotierung gesprochen, auch wenn die Dotierung offensichtlich jeweils umgekehrt ausgebildet sein kann.

Die n-Dotierung ist an der Vorderseite 11 ausgebildet und erstreckt sich durch die Innenwand der Löcher 14 bis an die Unterseite 12 des Halbleitersubstrats 13. Die Unterseite 12 weist neben den n-dotierten Bereichen 121 weitere, zweite Bereiche 122 auf, die eine p-Dotierung aufweisen. Es handelt sich hierbei um die p-Dotierung des Halbleitersubstrats 13, die ggf. durch zusätzliche Dotierung lokal verstärkt werden kann.

Die n-dotierten Bereiche 121 der Unterseite 12 sind mit ersten elektrischen Kontakten 31 in Form einer Fingerkontaktes verbunden. Die p-dotierten Bereiche 122 der Unterseite 12 sind mit zweiten elektrischen Kontakten 32, ebenfalls in Form eines Fingerkontakts verbunden. Die elektrischen Kontakte 31, 32 sind beispielsweise mittels einer Diffusionsbarriere (nicht dargestellt) elektrisch voneinander isoliert.

Bei dem dargestellten EWT-Zellkonzept liegen die Kontakte für beide Pole auf der Rückseite der Zelle. Der n-dotierte Emitterbereich wird durch viele die winzigen Löcher in der Zelle von der Vorder- auf die Rückseite geführt und erst dort kontaktiert.

Es wird darauf hingewiesen, dass die Figuren 1 und 2 nicht sämtliche Elemente einer kompletten EWT-Solarzelle zeigen. Es sind lediglich diejenigen Elemente dargestellt, die für das Verständnis der vorliegenden Erfindung erforderlich sind. Beispielsweise ist dem Fachmann bekannt, dass eine EWT-Solarzelle neben den dargestellten Elementen auf der Oberseite 11 zur Reflexionsminderung eine Texturierung sowie eine oder mehrere Passivierungsschichten, beispielsweise eine SiNₓ-Schicht aufweisen kann. Weiter können auf der Rückseite 12 ebenfalls Passivierungsschichten und/oder Diffusionsbarrieren zur elektrischen Trennung der ersten und zweiten elektrischen Kontakte 31, 32 vorgesehen sein. Die vorgesehenen elektrischen Kontakte 31, 32 können beispielsweise Aluminium und Silber aufweisen oder ausschließlich aus Silber bestehen. Dies sind nur Beispiele für weitere Ausgestaltungen, die die EWT-Solarzellen aufweisen können.

Es ist nun vorgesehen, dass die Vorderseite 11, die den Emitter bildet, angrenzend an die Löcher 14 lokale hochdotierte Bereiche 21 aufweist, die also beispielsweise eine n++-Dotierung aufweisen. Diese hochdotierten Bereiche 21 besitzen beispielsweise die Form eines Kreisrings, wie in der Fig. 1 dargestellt. Sie können jedoch auch andere Formen annehmen, beispielsweise sternförmig oder spiralförmig ausgebildet sein. Dabei sind die hochdotierten Bereiche 21 lokal in dem Sinne, dass sie sich nicht berühren und einander nicht überlappen.

Außerhalb dieser Bereiche in dem sonstigen Oberflächenbereich 22 ist die Oberfläche dagegen schwach dotiert (n+-Dotierung). In den hochdotierten Bereichen 21 liegt der Schichtwiderstand bevorzugt bei weniger als 30 Ohm/sq, vorzugsweise bei weniger als 15 Ohm/sq und in einer bevorzugten Ausgestaltung bei etwa 5 Ohm/sq. Im Bereich der restlichen Oberfläche 22 liegt eine schwache Dotierung mit einem Schichtwiderstand von beispielsweise mehr als 80 Ohm/sq vor.

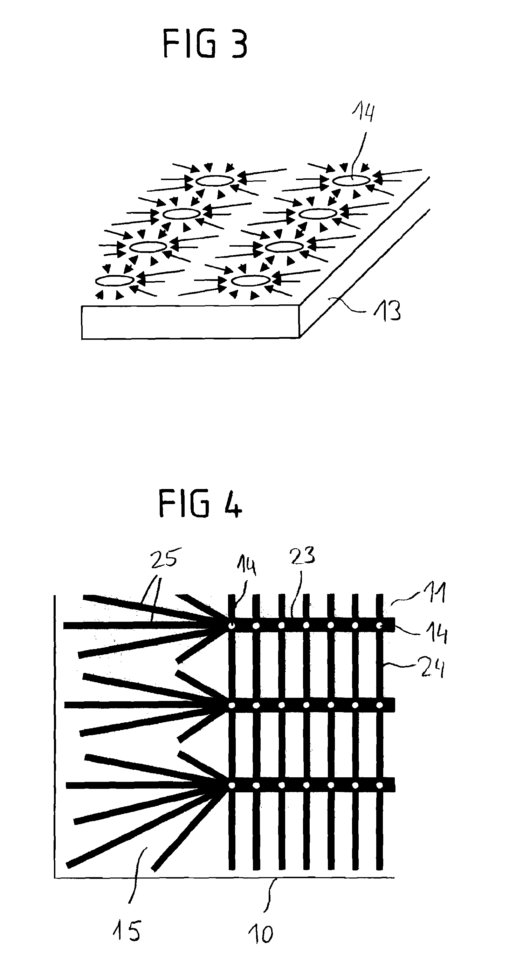

Aus Figur 3 ist erkennbar, dass die Stromdichte aufgrund des Umstandes, dass der Strom annähernd radial auf ein Loch 14 zufließt, mit abnehmendem Abstand zum Loch 14 zunimmt, so dass im Umgebungsbereich eines Loches 14 die höchste Stromdichte auftritt. Durch die Hochdotierung dieses Umkreises der Löcher 14 wird der Schichtwiderstand der EWT-Solarzelle reduziert. Gleichzeitig besitzt der überwiegende Teil 22 der Vorderseite 11 einen Emitter mit einer schwachen Dotierung und dementsprechend einer hohen Blauempfindlichkeit (d.h. einer guten Fähigkeit, kurzwelliges Licht in Strom umzuwandeln).

Die Figur 4 zeigt ein alternatives Ausführungsbeispiel einer EWT-Solarzelle, bei dem auf der Oberseite 11 der Solarzelle bestimmte lokale Bereiche hochdotiert sind. Es sind hierzu im Ausführungsbeispiel der Figur 4 in Zeilen ausgebildete hochdotierte Bereiche 23, in Reihen ausgebildete hochdotierte Bereiche 24 und längliche, fingerförmige schmale Bereiche 25 vorgesehen. An den Kreuzungspunkten der hochdotierten Zeilen und Spalten 23, 24 sind die Löcher 14 angeordnet, so dass die Vorderseite in unmittelbarer Umgebung der Löcher 14 ebenso wie im Ausführungsbeispiel der Figuren 1, 2 hochdotiert ist.

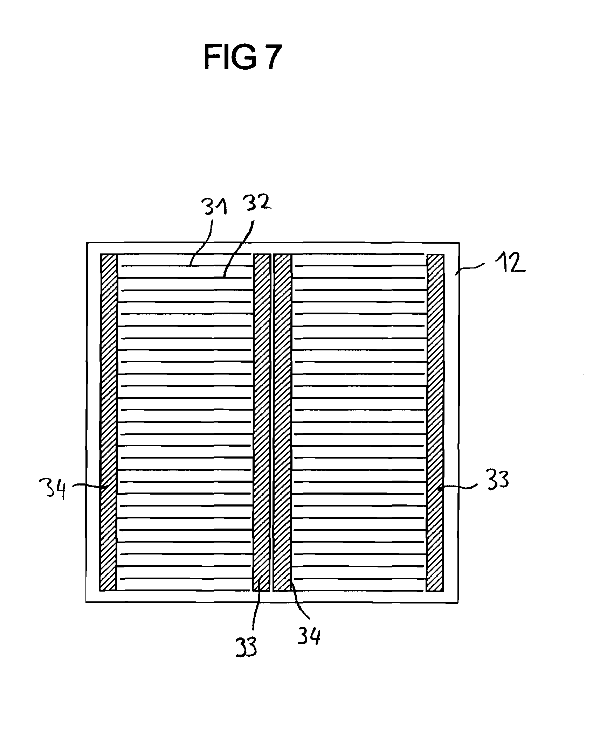

Die Finger 25 erstrecken sich, ausgehend von einem Loch 14, fächerförmig in einen lochfreien Bereich 15. Ein solcher lochfreier Bereich entsteht beispielsweise dadurch, dass auf der Rückseite eine Stromsammelschiene (Busbar), eine Lötstelle oder ähnliches (vgl. auch Figur 7) ausgebildet ist und daher in diesem Bereich keine Löcher ausgebildet werden können. Dies führt aber dazu, dass der lochfreie Bereich 15 einen großen Abstand zum nächsten Loch 14 besitzt. Dieser große Abstand kann nachteilig zu einem großen parasitären elektrischen Serienwiderstand führen. Durch die Ausbildung hochdotierter Finger 25 wird erreicht, dass die in dem lochfreien Bereich 15 erzeugten Leitungsträger über gut leitende Strompfade auf die Löcher 14 und von diesen auf die Zellrückseite 11 zu den entsprechenden Kontakten 31, 32 geleitet werden können.

Entsprechende Finger können beispielsweise auch an Randbereichen der Solarzelle 10 oder jeweils zwischen zwei Löchern 14 eines Rasters ausgebildet sein, wenn eine geringe Anzahl von Löchern in der Solarzelle vorliegt und das Raster dementsprechend groß ist. Auch wird darauf hingeweisen, dass entsprechende Finger, die sich in lochfreie Bereiche erstrecken, in Kombination mit der Ausgestaltung der Figur 1 realisiert werden können.

Die Finger 25 weisen beispielsweise eine Breite kleiner oder gleich 50 µm auf. In einer Ausgestaltung weisen die Finger 25 eine variable Breite auf, wobei sie sich bevorzugt zu ihrem dem zugehörigen Loch abgewandten Ende hin verjüngen.

Es wird darauf hingewiesen, dass die Ausgestaltung der Figuren 1, 2 und 4 nur beispielhaft zu verstehen sind. Die hochdotierten Bereiche können auch eine andere Geometrie aufweisen, beispielsweise viereckig oder oval um die einzelnen Löcher herum angeordnet sein. Auch können die fingerartigen Bereiche 25 beispielsweise jeweils nur einen Finger umfassen, der gerade oder gekrümmt (auch schneckenförmig) ausgebildet ist.

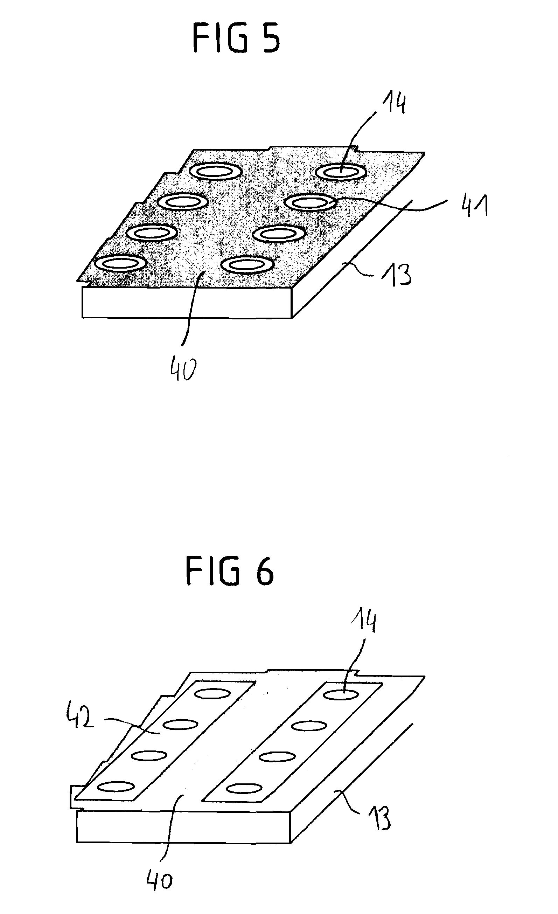

Zur Herstellung der hochdotierten Bereiche auf der Oberseite 11 der Solarzellen ist die Aufbringung einer Diffusionsmaske auf das Halbleitersubstrat 13 und eine Strukturierung dieser Diffusionsmaske vorgesehen. Die Figur 5 zeigt eine auf das Halbleitersubstrat 13 aufgebrachte Diffusionsmaske 40, die im Bereich der Löcher 14 kreisförmige, lokale Aussparungen 41 aufweist. Die Figur 6 zeigt eine auf das Halbleitersubstrat 13 aufgebrachte Diffusionsmaske 40, die linienförmige bzw. streifenförmige Aussparungen 42 aufweist, die jeweils eine Lochreihe umfassen. Die Maske 40 dient jeweils der Maskierung einer starken Diffusion, beispielsweise mit Phosphor. Die Maske der Figur 6 ist dabei gegenüber der Maske der Figur 5 leichter herzustellen, führt aber zu einer EWT-Solarzelle mit einer geringeren Effizienz aufgrund einer geringeren Blauempfindlichkeit.

Eine Maske gemäß den Figuren 5 oder 6 wird beispielsweise dadurch erzeugt, dass zunächst ganzflächig eine Diffusionsmaske 40 auf das Halbleitersubstrat 13 aufgebracht wird. Hierzu wird das Halbleitersubstrat 13 beispielsweise oxidiert, so dass eine SiO₂- Schicht entsteht. Eine Diffusionsbarriere kann jedoch auch in anderer Weise hergestellt werden.

Die beispielsweise aus Siliziumdioxid bestehende Diffusionsmaske 40 weist eine Dicke von beispielsweise 200 nm auf. Diese Schicht wird von den Dotierstoffen innerhalb der üblichen Diffusionsbedingungen nicht durchdrungen: da Oxid die Diffusion behindert, wirkt auch das natürliche Oberflächenoxid störend und verhindert ein gleichmäßiges Eindringen des Dotierstoffes in den Siliziumkristall.

Die Diffusionsmaske 40 wird zumindest auf der Vorderseite der Solarzelle aufgebracht, bevorzugt jedoch sowohl auf der Vorder- als auch auf der Rückseite.

Vor oder nach Herstellung der Löcher (bevorzugt nach Herstellung der Löcher) erfolgt ein selektives Entfernen der Diffusionsmaske in den Teilbereichen 41 bzw. 42 der Figuren 5 und 6. Das selektive Entfernen der Diffusionsmaske in diesen Bereichen kann auf verschiedene Weise erfolgen.

Eine erste Ausgestaltung hierzu sieht vor, dass eine Ätzpaste in den entsprechenden Bereichen auf der Vorderseite aufgebracht wird. In der Ausgestaltung der Figur 5 wird Ätzpaste in runden Bereichen 41, die jeweils ein Loch 14 enthalten, aufgebracht. In der Ausgestaltung der Figur 6 wird die Ätzpaste streifenförmig aufgebracht, wobei jeder Streifen 42 eine Lochreihe enthält. Die Ätzpaste entfernt in den aufgebrachten Bereichen die Diffusionsmaske.

In einem zweiten Ausführungsbeispiel erfolgt das Abtragen des Maskenmaterials in den fraglichen Bereichen 41, 42 durch Laserablation. Es wird ein linien- oder punktförmiger Laserspot verwendet.

In einer dritten Ausgestaltung wird die Diffusionsmaske durch eine strukturierte Ätzschicht geätzt. Die strukturierte Ätzschicht wird beispielsweise durch Siebdruck, ein Inkjet-Verfahren oder Dispensen aufgebracht.

Eine vierte Ausführungsvariante nutzt den Kapillareffekt. Es wird dabei die Unterseite 12 der Solarzelle 10 in eine Ätzlösung getaucht. Aufgrund des Kapillareffektes wird die Ätzlösung durch die Löcher 14 zur Vorderseite 11 hindurchgezogen. Hierbei wird ein lokaler Bereich um die Löcher 14 herum geätzt, wobei etwas Ätzlösung aus den Löchern heraus fließt und/oder ein Ätzen durch die Dämpfe der Lösung erfolgt.

Nach dem selektiven Entfernen der Diffusionsmaske 40 in den Teilbereichen 41, 42 der Vorderseite erfolgt nun eine starke Diffusion eines Dotierstoffes. Beispielsweise erfolgt eine starke Diffusion mit Phosphor. Hierzu kann vorgesehen sein, dass die Diffusion im Durchströmverfahren erfolgt, wobei ein Trägergas (Ar, N₂) von einer Quelle in gewünschtem Maße mit Dotierstoff angereichert und in ein Quarzrohr geleitet wird, in dem sich das Halbleitersubstrat befindet. Als Dotierstoffquelle wird beispielsweise PH₃ verwendet. Alternativ wird eine flüssige Dotierstoffquelle, beispielsweise POCl₃ benutzt. Die jeweilige Flüssigkeit befindet sich dann in einem temperierten Bubbler-Gefäß, das vom Trägergas durchspült wird. Mit dem Trägergas gelangt der Dotierstoff zur Diffusion in das Quarzrohr.

Ebenso ist es beispielsweise möglich, eine starke Diffusion über eine aufgedruckte Diffusionspaste durchzuführen, wie beispielsweise in der US 2005/07 61 64 A1 beschrieben.

Nach Durchführen der starken Diffusion wird die Diffusionsmaske 40 vollständig von der Zellvorderseite 11 entfernt. Anschließend erfolgt eine leichte Diffusion zur Bereitstellung schwach dotierter Bereiche auf der Vorderseite der Solarzelle. Die leichte Diffusion erfolgt beispielsweise ebenfalls mittels Phosphor.

Es schließen sich weitere Prozesse wie Passivierungsprozesse, Prozesse zur Bereitstellung einer Texturierung der Oberseite und Prozesse zur Herstellung positiver und negativer Kontakte auf der Rückseite der Solarzelle in entsprechenden Bereichen an. Diese weiteren Schritte sind jedem Fachmann an sich bekannt, so dass hierauf nicht weiter eingegangen wird.

Die Figur 7 zeigt eine typische Struktur einer stromsammelnden Rückseitenkontaktierung einer EWT-Solarzelle. Die Rückseite weist erste Fingerkontakte 31 einer positiven Polarität, zweite Fingerkontakte 32 einer negativen Polarität sowie insgesamt vier Stromsammelschienen (Busbars) 33, 34 auf, von denen jeweils zwei gleicher Polarität sind. Die über die Fingerkontakte 31, 32 gesammelten Ströme werden über die Busbars 33, 34 von der Solarzelle abgegriffen.

## Patentansprüche

1. Solarzelle (10) aufweisend:
- ein planares Halbleitersubstrat (13) mit einer Vorderseite (11) und einer Rückseite (12),
- eine Mehrzahl von Löchern (14), die die Vorderseite (11) und die Rückseite (12) verbinden, und
- ausschließlich auf der Rückseite (12) angeordnete stromsammelnde elektrische Kontakte (31, 32), wobei
- die Vorderseite (11) eine Dotierung eines ersten Typs aufweist,
- die Innenwand der Löcher (14) eine Dotierung des ersten Typs oder eine Metallisierung aufweist,
- die Rückseite (12) erste Bereiche (121) aufweist, die die Löcher (14) umfassen und die eine Dotierung des ersten Typs aufweisen, sowie zweite Bereiche (122), die eine Dotierung eines zweiten Typs aufweisen,
- die stromsammelnden elektrischen Kontakte (31, 32) erste Kontakte (31), die die ersten Bereiche (121) der Rückseite (12) kontaktieren, und zweite Kontakte (32), die die zweiten Bereiche (122) der Rückseite (12) kontaktieren, umfassen,
- die Vorderseite (11) hochdotierte Bereiche (21, 23, 24, 25) und schwach dotierte Bereiche (22) des ersten Typs derart aufweist, dass die Löcher (14) jeweils in einem hochdotierten Bereich (21, 23, 24, 25) liegen oder an einen solchen angrenzen,
**dadurch gekennzeichnet,**
**dass** das Halbleitersubstrat (13) und damit die Vorderseite (11) mindestens einen Bereich (15) ohne Löcher aufweist und die hochdotierten Bereiche der Vorderseite einen oder mehrere Bereiche (25) umfassen, die sich in den mindestens einen lochfreien Bereich (15) erstrecken.

2. Solarzelle nach Anspruch 2, **dadurch gekennzeichnet, dass** die hochdotierten Bereiche der Vorderseite einen oder mehrere fingerförmige Bereiche (25) umfassen, die sich in den mindestens einen lochfreien Bereich (15) erstrecken.

3. Solarzelle nach Anspruch 3, **dadurch gekennzeichnet, dass** die fingerförmigen Bereiche (25) jeweils geradlinig ausgebildet sind.

4. Solarzelle nach Anspruch 2 oder 3, **dadurch gekennzeichnet, dass** zumindest einige der fingerförmigen Bereiche (25) eine variable Breite aufweisen.

5. Solarzelle nach Anspruch 4, **dadurch gekennzeichnet, dass** die fingerförmigen Bereiche (25) sich zu ihrem Ende hin verjüngen.

6. Solarzelle nach einem der Ansprüche 2 bis 5, **dadurch gekennzeichnet, dass** eine Mehrzahl fingerförmiger Bereiche (25) sich ausgehend von einem Loch (14) fächerförmig in einen lochfreien Bereich (15) erstreckt.

7. Solarzelle nach einem der Ansprüche 2 bis 6, **dadurch gekennzeichnet, dass** die fingerförmigen Bereiche (25) eine Breite von ≤ 50 µm aufweisen.

8. Solarzelle nach einem der Ansprüche 2 bis 7, **dadurch gekennzeichnet, dass** die fingerförmigen Bereiche (25) in Gräben des Halbleitersubstrats (13) ausgebildet sind.

9. Solarzelle nach einem der vorangehenden Ansprüche, **dadurch gekennzeichnet, dass** die schwach dotierten Bereiche (22) der Vorderseite einen Schichtwiderstand von ≥ 80 Ohm/sq aufweisen.

10. Solarzelle nach einem der vorangehenden Ansprüche, **dadurch gekennzeichnet, dass** die hochdotierten Bereiche (21, 23, 24, 25) einen Schichtwiderstand kleinergleich 30 Ohm/sq, insbesondere kleinergleich 15 Ohm/sq, insbesondere von etwa 5 Ohm/sq aufweisen.

11. Solarzelle nach einem der vorangehenden Ansprüche, **dadurch gekennzeichnet, dass** die hochdotierten Bereiche (21, 23, 24, 25) in auf dem Halbleitersubstrat (13) ausgebildeten Gräben ausgebildet sind.

12. Solarzelle nach einem vorangehenden Ansprüche, **dadurch gekennzeichnet, dass** auch die Innenwand (141) der Löcher (14) hochdotiert ist.

13. Solarzelle nach einem der vorangehenden Ansprüche, **dadurch gekennzeichnet, dass** auch die auf der Rückseite (12) angeordneten Bereiche (121) der Dotierung des ersten Typs hochdotiert sind.

14. Solarzelle nach einem der vorangehenden Ansprüche, **dadurch gekennzeichnet, dass** die Dotierung des ersten Typs eine n-Dotierung und die Dotierung des zweiten Typs eine p-Dotierung ist, oder umgekehrt.

15. Solarzelle nach einem der vorangehenden Ansprüche, **dadurch gekennzeichnet, dass** die Löcher (14) in einem Raster angeordnet sind und der Abstand zwischen zwei Löchern (14) in einer Richtung zwischen 0,2 und 0,8 mm und in der Richtung senkrecht dazu zwischen 1 und 2,5 mm beträgt.
